# FASCICULE DE BREVET EUROPEEN

(11) **EP 0 967 712 B1**
(45) Date de publication et mention de la délivrance du brevet: **09.06.2010**
(21) Numéro de dépôt: 99401574.1
(22) Date de dépôt: 24.06.1999
(51) Int. Cl.: H02K 19/36, H01L 25/16

(54) **Sous-ensemble à composants électroniques pour un alternateur de véhicule automobile**
Unterbaugruppe mit elektronischen Bauelementen für eines Fahrzeugswechselstromgenerators
Sub-assembly with electronic components for an alternator of motor vehicle

(30) Priorité: 26.06.1998 FR 9808126
(43) Date de publication de la demande: 29.12.1999
(73) Titulaire: VALEO EQUIPEMENTS ELECTRIQUES MOTEUR, 94000 Créteil (FR)
(72) Inventeur: Vandenbossche, Mathieu, 75020 Paris (FR)

(56) Documents cités:
- EP-A- 0 258 691
- US-A- 4 992 688
- US-A- 5 386 343
- US-A- 5 677 616
- US-A- 5 747 875

## Description

L'invention concerne les sous-ensembles tels que porte-balais ou connecteurs, pour alternateur de véhicule automobile.

Dans un alternateur, il est courant de prévoir sur le porte-balais ou le connecteur, un substrat et un composant à circuit intégré, ou puce, monté dans un orifice traversant du substrat. Un tel montage est parfois appelé à puce nue. Lorsque le sous-ensemble comporte en outre un composant électronique élémentaire tel qu'une inductance, un condensateur, une résistance, ou une diode, on emploie un composant traversant le substrat que l'on soude, par brasure ou soudure électrique, sur des traces conductrices associées à la puce. Toutefois, ce montage génère une opération de montage et de soudage spécifique. Cela rend la fabrication longue et coûteuse. De plus, il faut prévoir des connexions spécifiques sur les pièces du sous-ensemble et protéger les soudures contre la corrosion et les courts-circuits.

On connaît par ailleurs an dispositif comportant un substrat présentant un orifice, un composant à circuit intégré monté dans l'orifice et un composant électronique fixé en surface sur le substrat, ce dernier présentant un évidement continu à l'orifice, et son procédé de fabrication par le document US 5 386 343.

Un but de l'invention est de fournir un sous-ensemble dont la fabrication soit moins longue et moins coûteuse.

En vue de la réalisation de ce but, on prévoit selon l'invention un sous-ensemble à régulateur pour un alternateur selon la revendication 1, comportant un substrat présentant un orifice, un composant à circuit intégré monté dans l'orifice et un composant électronique élémentaire autre qu'un circuit intégré, fixé au substrat, dans lequel le composant élémentaire est monté en surface sur le substrat, le substrat présente un évidement contigu à l'orifice, le composant élémentaire étant monté dans l'évidement, le composant élémentaire comprend un condensateur et est connecté directement à une masse du sous-ensemble et à une borne du composant à circuit intégré.

Ainsi, on peut déposer le composant élémentaire sur le substrat en même temps qu'on dépose le composant intégré. Par conséquent, ces deux dépôts peuvent être faits consécutivement par la même machine. Il n'est donc pas nécessaire de prévoir une étape de pose spécifique pour le composant élémentaire. On accélère ainsi la fabrication et on réduit le prix de revient du sous-ensemble. En outre, le matériau d'attache au substrat, colle ou brasure, peut être le même pour les deux composants, ce qui génère également une économie.

Avantageusement, le composant à circuit intégré et le composant élémentaire sont noyés dans une couche commune ininterrompue de matériau de protection.

Avantageusement, le sous-ensemble comporte un capot recouvrant le composant à circuit intégré et le composant élémentaire.

Avantageusement, il s'agit d'un sous-ensemble comportant des moyens de montage de balais.

Avantageusement, il s'agit d'un connecteur.

On prévoit également selon l'invention un alternateur notamment pour véhicule automobile, comprenant un sous-ensemble selon l'invention.

On prévoit en outre selon l'invention un procédé de fabrication d'un sous-ensemble à régulateur pour un alternateur, selon la revendication 7.

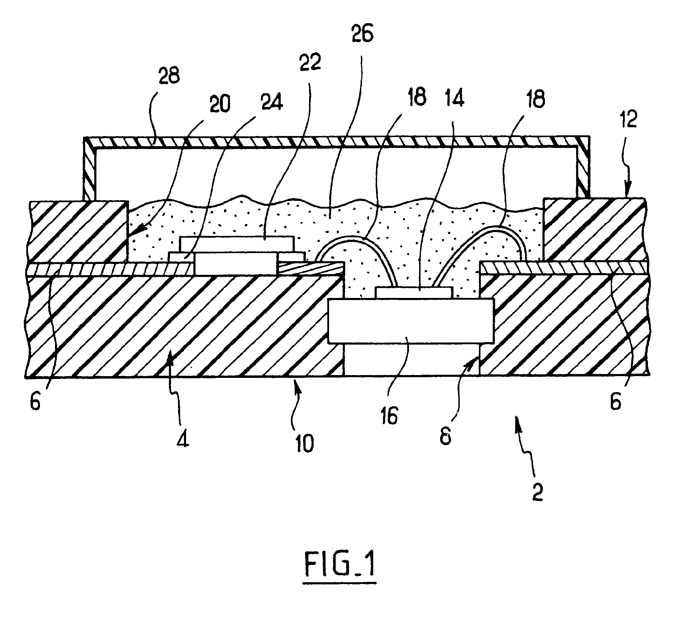

D'autres caractéristiques et avantages de l'invention apparaîtront encore dans la description suivante d'un mode préféré de réalisation donné à titre d'exemple non limitatif. Aux dessins annexés :
- la figure unique est une vue partielle en coupe d'un sous-ensemble pour alternateur selon l'invention.

En référence à la figure unique, l'alternateur pour véhicule automobile selon l'invention comprend un sous-ensemble 2 qui peut être un porte-balais ou un connecteur. Ce sous-ensemble comporte un substrat 4 en matière plastique dont la tranche est visible sur la figure, et des traces métalliques conductrices 6 sur lesquelles le substrat 4 a été surmoulé et qui sont ainsi pour l'essentiel noyées dans le substrat. Le substrat 4 présente un orifice ici traversant 8 débouchant sur deux faces planes opposées 10, 12 du substrat, ou au minimum sur la face 12.

Le sous-ensemble comporte un régulateur 14 sous la forme d'un circuit intégré, ou puce, fixé à un radiateur 16 et au moyen de ce dernier logé dans l'orifice débouchant 8. Le régulateur 14 est fixé du côté du radiateur 16 situé vers la face supérieure 12 du substrat 4. Le sous-ensemble comporte des câbles 18 pour connecter le régulateur 14 aux traces métalliques 6, et via celles-ci, à d'autres parties du sous-ensemble.

Le substrat 4 présente un évidement ou cavité non traversant 20 contigu à l'orifice 8, entourant ce dernier et ouvert du côté de la face supérieure 12 du substrat en exposant au jour une partie des traces métalliques 6. Le sous-ensemble comporte un composant électronique élémentaire 22 autre qu'un circuit intégré. Il s'agit en l'espèce d'un condensateur, mais il pourrait s'agir aussi bien d'une diode, d'une résistance ou d'une inductance. Ce composant élémentaire 22 est monté en surface dans l'évidement 20, et à cette fin collé au substrat 4 et aux traces 6 par une colle conductrice 24.

Un matériau de protection tel qu'un gel de silicone 26 remplit l'évidement 20 et l'orifice 8 au-dessus du radiateur 16 de sorte que les deux composants 14, 22 sont noyés dans la couche ainsi constituée. Le sous-ensemble comporte un capot de protection 28 en matière plastique fixé à la face supérieure 12 du substrat 4 et recouvrant le gel 26, avec les deux composants 14, 22.

Pour fabriquer le sous-ensemble 2, on monte sur le substrat 4 au moyen de la même machine et au moyen du même matériau d'attache (colle 24 ou brasure) successivement le composant à circuit intégré 14 et le composant élémentaire 22. Puis on les noie dans la couche commune de gel silicone 26. Enfin, on installe le capot 28.

Le composant élémentaire 22 est par exemple un condensateur connecté directement d'une part à une borne d'alimentation du régulateur 14 et d'autre part à une masse du sous-ensemble. Avec différents condensateurs montés de cette façon, on stabilise les alimentations internes des puces, ou on protège les entrées/sorties contre les décharges électrostatiques.

On pourra prévoir sur le sous-ensemble plusieurs composants à circuits intégrés 14 et/ou plusieurs composants élémentaires 22.

Les deux composants 14, 22 pourront être protégés par des couches 26 disjointes et/ou par des capots 28 distincts. Ils pourront s'étendre dans des évidements disjoints du substrat.

## Revendications

1. Sous-ensemble (2) à régulateur pour un alternateur, comportant un substrat (4) présentant un orifice (8), un composant à circuit intégré (14) monté dans l'orifice et un composant électronique, fixé en surface sur le substrat,
le substrat (4) présentant un évidement (20) contigu à l'orifice (8), **caractérisé en ce que** le composant électronique est un composant élémentaire (22) autre qu'un circuit intégré, il est monté dans l'évidement (20), connecté directement à une borne du composant à circuit intégré (14) et à une masse du sous-ensemble (2), et il comprend un condensateur.

2. Sous-ensemble selon la revendication 1, **caractérisé en ce que** le composant à circuit intégré (14) et le composant élémentaire (22) sont noyés dans une couche commune (26) ininterrompue de matériau de protection.

3. Sous-ensemble selon l'une quelconque des revendications 1 à 2, **caractérisé en ce qu'**il comporte un capot (28) recouvrant le composant à circuit intégré (14) et le composant élémentaire (22).

4. Sous-ensemble selon l'une quelconque des revendications 1 à 3, **caractérisé en ce qu'**il s'agit d'un sous-ensemble comportant des moyens de montage de balais.

5. Sous-ensemble selon l'une quelconque des revendications 1 à 3, **caractérisé en ce qu'**il s'agit d'un connecteur.

6. Alternateur notamment pour véhicule automobile, **caractérisé en ce qu'**il comprend un sous-ensemble (2) selon l'une des revendications 1 à 5.

7. Procédé de fabrication d'un sous-ensemble (2) à régulateur pour un alternateur, dans lequel on monte un composant à circuit intégré (14) dans un orifice traversant (8) d'un substrat (4) du sous-ensemble, on fixe en surface du substrat un composant électronique, **caractérisé en ce que** le composant électronique étant un composant élémentaire autre qu'un circuit intégré on monte celui-ci dans un évidement (20) formé dans le substrat et contigu à l'orifice (8), on connecte directement le composant élémentaire (22) à une borne du composant à circuit intégré (14) et à une masse du sous-ensemble (2), le composant élémentaire comprenant un condensateur.

## Claims

1. Sub-assembly (2) with a regulator for an alternator, comprising a substrate (4) which has an aperture (8), a component (14) with an integrated circuit which is fitted in the aperture, and an electronic component which is secured to the surface of the substrate, the substrate (4) having a recess (20) which is adjacent to the aperture (8), **characterised in that** the electronic component is an elementary component (22) other than an integrated circuit, it is fitted in the recess (20), connected directly to a terminal of the component (14) with an integrated circuit and to an earth of the sub-assembly (2), and it comprises a capacitor.

2. Sub-assembly according to claim 1, **characterised in that** the component (14) with an integrated circuit and the elementary component (22) are embedded in an uninterrupted common layer (26) of protective material.

3. Sub-assembly according to either of claims 1 or 2, **characterised in that** it comprises a cover (28) which covers the component (14) with an integrated circuit and the elementary component (22).

4. Sub-assembly according to any one of claims 1 to 3, **characterised in that** it consists of a sub-assembly comprising means for fitting of brushes.

5. Sub-assembly according to any one of claims 1 to 3, **characterised in that** it consists of a connector.

6. Alternator, in particular for a motor vehicle, **characterised in that** it comprises a sub-assembly (2) according to one of claims 1 to 5.

7. Method for production of a sub-assembly (2) with a regulator for an alternator, wherein a component (14) with an integrated circuit is fitted in an aperture (8) which passes through a substrate (4) of the sub-assembly, and an electronic component is secured to the surface of the substrate, **characterised in that**, the component being an elementary component other than an integrated electronic circuit, the component is fitted in a recess (20) formed in the substrate and adjacent to the aperture (8), and the elementary component (22) is connected directly to a terminal of the component (14) with an integrated circuit and to an earth of the sub-assembly (2), the elementary component comprising a capacitor.

## Patentansprüche

1. Baugruppe (2) mit Regler für einen Wechselstromgenerator, umfassend ein Substrat (4), das eine Öffnung (8) aufweist, ein in der Öffnung angebrachtes Bauteil mit integrierter Schaltung (14) und ein elektronisches Bauteil, das an der Oberfläche auf dem Substrat befestigt ist, wobei das Substrat (4) eine an die Öffnung (8) angrenzende Aussparung (20) aufweist, **dadurch gekennzeichnet, dass** das elektronische Bauteil ein Bauelement (22) ist, bei dem es sich nicht um eine integrierte Schaltung handelt und das in der Aussparung (20) angebracht und direkt an eine Klemme des Bauteils mit integrierter Schaltung (14) und an eine Masse der Baugruppe (2) angeschlossen ist und einen Kondensator umfasst.

2. Baugruppe nach Anspruch 1, **dadurch gekennzeichnet, dass** das Bauteil mit integrierter Schaltung (14) und das Bauelement (22) in eine durchgehende gemeinsame Schicht (26) aus Schutzwerkstoff eingelassen sind.

3. Baugruppe nach einem der Anspruche 1 bis 2, **dadurch gekennzeichnet, dass** sie eine Abdeckung (28) umfasst, die das Bauteil mit integrierter Schalung (14) und das Bauelement (22) bedeckt.

4. Baugruppe nach einem der Ansprüche 1 bis 3, **dadurch gekennzeichnet, dass** es sich um eine Baugruppe handelt die Mittel zur Anbringung von Kohlebürsten umfasst.

5. Baugruppe nach einem der Ansprache 1 bis 3. **dadurch gekennzeichnet, dass** es sich um einen Verbinder handelt.

6. Wechselstromgenerator, insbesondere für Kraftfahrzeuge, **dadurch gekennzeichnet, dass** er eine Baugruppe (2) nach einem der Ansprüche 1 bis 5 umfasst.

7. Verfahren zur Herstellung einer Baugruppe (2) mit Regler für einen Wechselstromgenerator, bei dem ein Bauteil mit integrierter Schaltung (14) in einer durchgehenden Öffnung (8) eines Substrats (4) der Baugruppe angebracht und an der Oberfläche des Substrats ein elektronisches Bauteil befestigt wird, **dadurch gekennzeichnet, dass** das elektronische Bauteil, das ein Bauelement ist, bei dem es sich nicht um eine integrierte Schaltung handelt, in eine in das Substrat eingearbeitete und an die Öffnung (8) angrenzende Aussparung (20) eingesetzt wird und das Bauelement (22) direkt an eine Klemme des Bauteils mit integrierter Schaltung (14) und an eine Masse der Baugruppe (2) angeschlossen wird, wobei das Bauelement einen Kondensator umfasst.
